# EUROPÄISCHE PATENTSCHRIFT

(11) **EP 2 471 113 B1**
(45) Veröffentlichungstag und Bekanntmachung des Hinweises auf die Patenterteilung: **01.10.2014**
(21) Anmeldenummer: 10731537.6
(22) Anmeldetag: 15.07.2010
(51) Int. Cl.: H01L 35/32, F01N 5/02

(54) **THERMOELEKTRISCHE VORRICHTUNG**
THERMOELECTRIC DEVICE
DISPOSITIF THERMOÉLECTRIQUE

(30) Priorität: 28.08.2009 DE 102009039228
(43) Veröffentlichungstag der Anmeldung: 04.07.2012
(73) Patentinhaber: Emitec Gesellschaft für Emissionstechnologie mbH, 53797 Lohmar (DE)
(72) Erfinder: BRÜCK, Rolf, 51429 Bergisch Gladbach (DE); LIMBECK, Sigrid, 53804 Much (DE)
(74) Vertreter: Rössler, Matthias
(86) Internationale Anmeldenummer: PCT/EP2010/060186
(87) Internationale Veröffentlichungsnummer: WO 2011/023451

(56) Entgegenhaltungen:
- EP-A1- 1 193 774
- EP-A2- 1 580 819
- WO-A2-2009/082534

## Beschreibung

Die vorliegende Erfindung betrifft eine thermoelektrische Vorrichtung zur Erzeugung elektrischer Energie, z. B. aus dem Abgas einer Verbrennungskraftmaschine, mittels eines thermoelektrischen Generators. Damit ist insbesondere ein Generator zur Umwandlung thermischer Energie eines Abgases in elektrische Energie gemeint.

Das Abgas aus einem Motor eines Kraftfahrzeuges besitzt thermische Energie, welche mittels eines thermoelektrischen Generators bzw. Apparates in elektrische Energie umgewandelt werden kann, um bspw. eine Batterie oder einen anderen Energiespeicher zu füllen oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeuges Energie in größerem Umfang zur Verfügung.

Ein solcher thermoelektrischer Generator weist zumindest eine Mehrzahl thermoelektrischer Wandlerelemente auf. Thermoelektrische Wandlerelemente sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des "Seebeck-Effektes" und ein Phänomen, welches mit Wärmeadsorption einhergeht und in Relation zu einem Stromfluss durch unterschiedliche Materialien verursacht wird. Der "Peltier-Effekt" ist bspw. zum thermoelektrischen Kühlen bereits vorgeschlagen worden.

Solche thermoelektrischen Wandlerelemente weisen bevorzugt eine Vielzahl von thermoelektrischen Elementen auf, die zwischen einer sogenannten Heißseite und einer sogenannten Kaltseite positioniert sind. Thermoelektrische Elemente umfassen z. B. wenigstens zwei Halbleiterelemente (p- und n-dotiert), die auf ihrer Ober- und Unterseite (hin zur Heißseite bzw. Kaltseite) wechselseitig mit elektrisch leitenden Brücken versehen sind. Keramikplatten bzw. Keramikbeschichtungen und/oder ähnliche Materialien dienen zur elektrischen Isolierung der Metallbrücken und sind somit bevorzugt zwischen den Metallbrücken angeordnet. Wird ein Temperaturgefälle beidseits der Halbleiterelemente bereitgestellt, so bildet sich ein Spannungspotential aus. Auf der Heißseite des ersten Halbleiterelements wird dabei Wärme aufgenommen, wobei die Elektronen der einen Seite auf das energetisch höherliegende Leitungsband des folgenden Halbleiterelements gelangen. Auf der Kaltseite können die Elektronen nun Energie freisetzen und auf das folgende Halbleiterelement mit niedrigerem Energieniveau gelangen. Somit kann sich bei einem entsprechenden Temperaturgefälle ein elektrischer Stromfluss einstellen.

Der bei einem thermoelektrischen Generator in einer Abgasanlage eines Kraftfahrzeugs auftretende große Temperaturunterschied zwischen der Heißseite und der Kaltseite ist eine hohe Belastung für die verwendeten Materialien und deren Gefüge. Die Temperaturen bei einem thermoelektrischen Generator betragen in einer Abgasanlage auf der Kaltseite typischerweise zwischen 20 °C und 110 °C und auf der Heißseite zwischen 150 °C und 500 °C. Der große Temperaturunterschied führt zu einer unterschiedlich starken Ausdehnung der Materialien an der Heißseite und der Kaltseite. Die unterschiedlich starke Ausdehnung wiederum führt zu Spannungen in dem thermoelektrischen Generator, welche auf Dauer den Zusammenhalt und/oder die Funktion des Generators beeinträchtigen können. Es wurden bereits Kompensationselemente im thermoelektrischen Generator vorgeschlagen, um die Spannungen zu mindern. Ein zusätzliches Kompensationselement in einem thermoelektrischen Generator erhöht jedoch den technischen Aufwand bei dessen Herstellung.

Die WO 2009/082534 A1 ist auf eine thermoelektrische Vorrichtung gerichtet, wobei zwischen zwei Trägerschichten thermoelektrische Elemente angeordnet sind. Die Dicken der zwei Trägerschichten und die Wärmeausdehnungskoeffizienten des verwendeten Materials werden unterschiedlich ausgeführt. Durch diese Ausgestaltung soll eine dauerhafte Kontaktierung der Halbleiterelemente mit den einzelnen Trägerschichten gewährleistet werden.

Die EP 1 193 774 A1 ist auf die Herstellung eines thermoelektrischen Elements gerichtet. Dabei wird auch das Problem der Empfindlichkeit der thermoelektrischen Materialien gegenüber Scherkräften, die durch unterschiedliche thermische Ausdehnung der verwendeten Materialen hervorgerufen werden, diskutiert. Es wird daher ein Mehrschicht-Material vorgeschlagen, dass zur Bildung eines thermoelektrischen Elements verwendet werden soll.

Hiervon ausgehend ist es Aufgabe der vorliegenden Erfindung, die mit Bezug auf den Stand der Technik geschilderten Probleme zumindest teilweise zu lösen. Insbesondere soll eine thermoelektrische Vorrichtung angegeben werden, die an den Einsatz in einem thermoelektrischen Generator in einer Abgasanlage angepasst ist. Die thermoelektrische Vorrichtung soll trotz des Temperaturunterschieds im Betrieb thermische Spannungen zwischen der Heiß- und der Kaltseite reduzieren.

Diese Aufgaben werden gelöst mit jeweils einer Vorrichtung gemäß den Merkmalen des Patentanspruchs 1 und 2 sowie durch ein Verfahren zur Herstellung der thermoelektrischen Vorrichtung gemäß dem Patentanspruch 8. Vorteilhafte Ausgestaltungen der erfindungsgemäßen Vorrichtung sowie die Integration dieser Vorrichtung in übergeordnete Baueinheiten sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die thermoelektrische Vorrichtung weist zumindest einen ersten Strömungskanal und zumindest einen zweiten Strömungskanal auf mit
- wenigstens einer dem zumindest einen ersten Strömungskanal zugeordneten ersten Trägerschicht und wenigstens einer dem zumindest einen zweiten Strömungskanal zugeordneten zweiten Trägerschicht,
- wenigstens einem Zwischenraum zwischen der ersten Trägerschicht und der zweiten Trägerschicht,
- einer Mehrzahl von p- und n-dotierten Halbleiterelementen, die in dem wenigstens einen Zwischenraum angeordnet und elektrisch miteinander verbunden ist,
wobei eine relative erste thermische Ausdehnung der ersten Trägerschicht und eine relative zweite thermische Ausdehnung der zweiten Trägerschicht unter Betriebsbedingungen gleich sind.

Die hier vorgeschlagene thermoelektrische Vorrichtung ist insbesondere zwischen einem einzelnen ersten Strömungskanal und einem einzelnen zweiten Strömungskanal, bzw. zwischen einer Vielzahl von ersten Strömungskanälen und einer Vielzahl von zweiten Strömungskanälen, angeordnet. Durch die Strömungskanäle beidseits der Vorrichtung werden jeweils Ströme von Fluiden geführt, das heißt Gase oder Flüssigkeiten. Eine Seite einer thermoelektrischen Vorrichtung wird als Heißseite bezeichnet, wobei die der Heißseite zugeordneten Strömungskanäle von heißem Fluid durchströmt werden. Die andere Seite einer thermoelektrischen Vorrichtung wird dementsprechend als Kaltseite bezeichnet, wobei die der Kaltseite zugeordneten Strömungskanäle von einem Fluid einer niedrigeren Temperatur durchströmt werden. Nachfolgend wird stets davon ausgegangen, dass der zumindest eine erste Strömungskanal die Heißseite und der zumindest eine zweite Strömungskanal die Kaltseite bilden. Dies kann generell aber auch vertauscht werden. Im Folgenden wird die erste Trägerschicht der Heißseite zugeordnet und die zweite Trägerschicht der Kaltseite, ohne jedoch die Erfindung auf diese Zuordnung zu beschränken. Bei einem Kraftfahrzeug wird regelmäßig die Heißseite den Gasen einer Abgasanlage zugeordnet und die Kaltseite der Flüssigkeit eines Kühlkreislaufs.

Insbesondere die dem wenigstens einen ersten Strömungskanal zugeordnete erste Trägerschicht und die dem wenigstens einen zweiten Strömungskanal zugeordnete zweite Trägerschicht bilden zumindest teilweise die Begrenzung der jeweiligen Strömungskanäle, also z.B. einen Teil der Wand einzelner oder mehrere Strömungskanäle. Die erste Trägerschicht und die zweite Trägerschicht stehen somit in thermischer Verbindung mit dem Fluid der Heißseite beziehungsweise mit dem Fluid der Kaltseite. Auf diese Weise wird ein Temperaturgefälle auf die zwischen den Trägerschichten angeordneten Halbleiterelemente übertragen, die aufgrund des "Seebeck-Effekts" einen Strom erzeugen können.

Die Trägerschichten bilden folglich die Begrenzung der thermoelektrischen Vorrichtung. Zwischen den Trägerschichten ist ein Zwischenraum vorgesehen, in dem die Halbleiterelemente angeordnet sind. Der Zwischenraum weist damit insbesondere eine Ausdehnung auf, die im Wesentlichen nur durch eine Höhe und eine Anzahl sowie durch die Anordnung der Halbleiterelemente vorgegeben ist. Zur Realisierung eines gezielten Stromflusses durch die p- und n-dotierten Halbleiterelemente können die Trägerschichten jeweils zumindest teilweise eine elektrische Isolationsschicht aufweisen, auf der die Halbleiterelemente fixiert und miteinander elektrisch verbunden sind. Bei der elektrischen Isolationsschicht ist darauf zu achten, dass diese den Wärmeübergang von einer Außenseite der Trägerschicht hin zu den Halbleiterelementen nicht übermäßig behindert.

Als leitfähige Materialien für die p- dotierten und n- dotierten Halbleiterelemente kann beispielsweise Wismut-Tellurit (Bi₂Te₃) eingesetzt werden. Darüber hinaus könnten folgende Materialien [bis zu folgenden Maximaltemperaturen in °C] eingesetzt werden:
n-Typ:
   Bi₂Te₃ [ca. 250 °C]; PbTe [ca. 500 °C]; Ba_{0,3}Co_{3,95}Ni_{0,05}Sb₁₂ [ca. 600 °C]; Ba_{y}(Co,Ni)₄Sb₁₂ [ca. 600 °C]; CoSb₃ [ca. 700 °C]; Ba₈Ga₁₆Ge₃₀ [ca. 850 °C]; La₂Te₃[ca. 1100 °C]; SiGe [ca. 1000 °C]; Mg₂(Si,Sn) [ca. 700 °C];
p-Typ:
   (Bi,Sb)₂TE₃ [ca. 200 °C]; Zn₄Sb₃[ca. 380 °C]; TAGS [ca. 600 °C]; PbTe [ca. 500 °C]; SnTe [ca. 600 °C]; CeFe₄Sb₁₂ [ca. 700 °C]; Yb₁₄MnSb₁₁ [ca. 1000 °C]; SiGe [ca. 1000 °C]; Mg₂(Si,Sb) [ca. 600 °C].

Bei der erfindungsgemäßen thermoelektrischen Vorrichtung werden also die zwei Trägerschichten zur Begrenzung des Zwischenraumes eingesetzt und für einen Wärmeübergang von den Strömungskanälen hin zu den Halbleiterelementen. Die Halbleiterelemente können dabei beispielsweise nach Art von kleinen Quadern aus unterschiedlich elektrisch leitfähigen Material bereitgestellt sein. Jeweils zwei unterschiedliche Halbleiterelemente (p-dotiert und n-dotiert) sind bevorzugt so miteinander elektrisch verbunden, dass sie zusammen eine Reihenschaltung ergeben. Eine der beiden Trägerschichten nimmt den einfließenden Wärmestrom auf (Heißseite), während die andere Trägerschicht den ausfließenden Wärmestrom abgibt (Kaltseite). Im Hinblick auf das Design der Anordnung, bzw. die Verschaltung der einzelnen Halbleiterelemente, können Art, Gestalt und und/oder Position der Halbleiterelemente an den Bauraum, den gewünschten Wärmefluss, die Stromführung etc. angepasst sein, wobei sie sich insbesondere auch hierbei unterscheiden können. Insbesondere weist die thermoelektrische Vorrichtung eine oder mehrere Gruppen von miteinander in Reihe geschalteten Halbleiterelementen auf, wobei die Gruppen jeweils voneinander unabhängige Stromkreise bilden oder miteinander über eine elektrische Parallelschaltung verbunden sind.

Die relative thermische Ausdehnung ergibt sich aus dem Produkt eines gemittelten Ausdehnungskoeffizienten der Trägerschicht und der Temperaturdifferenz, die diese Trägerschicht unter Betriebsbedingungen der thermoelektrischen Vorrichtung ausgesetzt ist. Mit dem gemittelten Ausdehnungskoeffizienten ist der Quotient aus einer Längenänderung bei einem Temperaturanstieg zu der Gesamtlänge bei einer Ruhetemperatur gemeint. Die Einheit des gemittelten Ausdehnungskoeffizienten ist 1/Kelvin. Die Längenänderung bei der Bestimmung des gemittelten Ausdehnungskoeffizienten wird hier als die Differenz der Länge der Trägerschicht bei der Ruhetemperatur und der Länge der Trägerschicht bei (maximaler) Betriebstemperatur definiert. Die Temperaturdifferenz ergibt sich aus der Differenz der (maximalen) Betriebstemperatur und der Ruhetemperatur (unter Betriebsbedingungen).

Die Ruhetemperatur liegt sowohl für die erste Trägerschicht als auch für die zweite Trägerschicht typischerweise zwischen -20 °C und 40 °C, bevorzugt zwischen 0 °C, und 20 °C, besonders bevorzugt bei genau 10 °C. Die (maximale) Betriebstemperatur einer Heißseite liegt zwischen 150 °C und 900 °C, bevorzugt zwischen 250 °C und 700 °C, besonders bevorzugt bei genau 325 °C (für thermoelektrische Vorrichtungen in einem Abgasrückführsystem) bzw. bei genau 625 °C (für thermoelektrische Vorrichtungen in einem Abgassystem am Unterboden eines Fahrzeuges). Die Betriebstemperatur einer Kaltseite liegt zwischen -20 °C und 120 °C, bevorzugt zwischen 50 °C und 80 °C, besonders bevorzugt bei genau 65 °C. Mögliche Messmethoden zur Bestimmung der Längenänderung sind dem Fachmann bekannt. Vorzugsweise werden die Messungen bei den besonders bevorzugten Temperaturen durchgeführt.

Bei einer "gleichen" Ausgestaltung der relativen ersten thermischen Ausdehnung der ersten Trägerschicht und der relativen zweiten thermischen Ausdehnung der zweiten Trägerschicht weichen die Werte nur unwesentlich voneinander ab, insbesondere mit einer Toleranz von (im Mittel oder sogar absolut) maximal 10 %, insbesondere maximal 1,0 oder sogar nur maximal 0,1 %.

Dies macht insbesondere deutlich, dass die erste Trägerschicht und die zweite Trägerschicht unterschiedliche gemittelte Ausdehnungskoeffizienten aufweisen, um eine gleiche Ausgestaltung der relativen thermischen Ausdehnungen zu bilden. Erfindungsgemäß wird also der große Temperaturunterschied zwischen der ersten Trägerschicht und der zweiten Trägerschicht, der normalerweise unterschiedlichen Ausdehnungen dieser Bauteile zu Folge hat, im Betrieb bzw. unter Betriebsbedingungen aufgrund der angepassten gemittelten Ausdehnungskoeffizienten kompensiert. Dabei sollte die kleinere relative thermische Ausdehnung innerhalb des angegeben Toleranzbereichs der größeren relativen thermischen Ausdehnung liegen.

Bei einer ersten Ausführungsvariante der erfindungsgemäßen thermoelektrischen Vorrichtung weist die erste Trägerschicht einen Ausdehnungskoeffizienten von 2 * 10⁻⁶/K bis 10,2 * 10⁻⁶/K und die zweite Trägerschicht einen Ausdehnungskoeffizienten von 12 * 10⁻⁶/K bis 28,4 *10⁻⁶ /K auf. Die angegebenen Ausdehnungskoeffizienten können aus messtechnischen Gründen mit einem Fehler von bis zu 5% behaftet sein und sind als "gemittelte" Werte angegeben.

Ganz besonders bevorzugt ist hier, dass die erste Trägerschicht einen Ausdehnungskoeffizienten von 5,5 * 10⁻⁶ /K bis 8 * 10⁻⁶/K und die zweite Trägerschicht einen Ausdehnungskoeffizienten von 18 * 10⁻⁶ /K bis 28,4 * 10⁻⁶ /K besitzt.

Durch die Wahl einer Legierung mit den bevorzugten Ausdehnungskoeffizienten besitzt die erste Trägerschicht einen Ausdehnungskoeffizienten, der dem der Halbleiterelemente nahezu entspricht, und die zweite Trägerschicht dehnt sich bei einem im Betrieb vorliegenden Temperaturunterschied von bis zu ca. 450 °C genauso stark aus wie die Trägerschicht der Heißseite. Test und Analysen haben hervorgebracht, dass mit derartigen Materialien eine besonders spannungsarme und damit auch unter sehr vielen Wechselbeanspruchungen langlebige thermoelektrische Vorrichtung bereit gestellt werden kann.

Zur Bestimmung des Ausdehnungskoeffizienten des verwendeten Materials der ersten Trägerschicht oder der zweiten Trägerschicht kann ein Teststreifen des Materials, welches entweder durch Ausbau aus der thermoelektrischen Vorrichtung oder als Rohmaterial erhältlich ist, zunächst einseitig eingespannt werden. Der Teststreifen wird nach der Vermessung bei der Ruhetemperatur durch Beaufschlagen mittels eines geeigneten Mediums auf eine (maximale) Betriebstemperatur erwärmt. Ist der Teststreifen genügend lange dem Medium ausgesetzt, so dass der Teststreifen komplett die Temperatur des Mediums angenommen hat, wird die Länge des Streifens in mindestens einer Dimension gemessen. Im Folgenden wird die Temperatur des Mediums gezielt um einige Grad erhöht und nach einer Zeit, in der der Teststreifen die Temperaturerhöhung annimmt, die Länge des Teststreifens abermals gemessen. Aus der Länge, der Differenz der Längenmessung und der Temperaturdifferenz lässt sich der Ausdehnungskoeffizient bestimmen.

Im Hinblick auf den Einsatz einer solchen Vorrichtung in einem Abgasrückführsystem liegt die Betriebstemperatur der Kaltseite typischerweise zwischen 50 °C und 80 °C (insbesondere exakt 65 °C) und der Heißseite zwischen 250 °C, und 400 °C (insbesondere exakt 325 °C). Für die Messung des Ausdehnungskoeffizienten eines Materials der Kaltseite kann ein Wasserbad mit einer geeigneten Heizplatte verwendet werden, mit der möglichst genau die Temperatur des Wasserbades geregelt werden kann. Ferner ist vorstellbar, dass der Teststreifen einem Fluidstrom, insbesondere einem Gasstrom, ausgesetzt wird, dessen Temperatur kontrolliert steuerbar ist. Ein solch heißer Fluidstrom ist auch für die Messung für ein Material der Heißseite geeignet. Ein Material der Heißseite kann aber auch in einem Ofen, dessen Temperatur sich genau steuern lässt, erwärmt werden.

Bei einer einer zweiten Ausfürungsvariante der erfindungsgemäßen thermoelektrischen Vorrichtung besteht zumindest die erste Trägerschicht oder die zweite Trägerschicht aus einer Legierung, bei der
- ein Anteil Nickel von mindestens 9,0 Gew.-%,
- ein Anteil Silizium von höchstens 1,0 Gew.-%,
- sowie mindestens ein Element aus der Gruppe Mangan, Chrom, Kohlenstoff, Molybdän, Kobalt, Aluminium, Titan, Kupfer und Niob und Eisen
enthalten ist.

Die vorteilhafte Legierung weist eine weite Spanne des Ausdehnungskoeffizienten bei ansonsten ähnlichen mechanischen und thermischen Eigenschaften auf. Der Ausdehnungskoeffizient der erfindungsgemäßen Legierung reicht von 1,0 * 10⁻⁶/K bis 31,7 * 10⁻⁶ /K in einem Temperaturbereich von 20 °C bis 500 °C. Die weite Spanne des Ausdehnungskoeffizienten erlaubt es, die Legierung der Trägerschichten sowohl an die gegebenen Betriebstemperaturen als auch an die Materialeigenschaften der verwendeten Halbleiterelemente anzupassen. Über den Nickelanteil der Legierung lässt sich der Ausdehnungskoeffizient in erheblichem Maße beeinflussen. So weist eine Eisen-Nickel-Legierung mit einem Nickelanteil von 36 Gew.-% ein Minimum des Ausdehnungskoeffizienten auf. Durch den Anteil von Silizium in der Legierung lässt sich deren Zugfestigkeit und Streckgrenze in erheblichem Maße beeinflussen. Neben den erfindungsgemäß angegebenen Stoffanteilen kann die Legierung auch typische Verunreinigungen aufweisen, die hier aber unbeachtlich sind.

Zumindest die erste Trägerschicht oder die zweite Trägerschicht besteht aus einer vorteilhaften Legierung. Bevorzugt ist jedoch, dass sowohl die erste Trägerschicht als auch die zweite Trägerschicht mit der erfindungsgemäßen Legierung ausgeführt sind.

Eine geeignete Wahl der erfindungsgemäßen Legierungen für die erste Trägerschicht und/oder die zweite Trägerschicht sorgt dafür, dass die absoluten Ausdehnungen der ersten Trägerschicht und der zweiten Trägerschicht im Betrieb der Vorrichtung ähnlich groß sind, obwohl ein Temperaturunterschied von bis zu 450 °C vorliegen kann. Auf diese Weise entstehen praktisch keine (signifikanten) Spannungen zwischen der ersten Trägerschicht und der zweiten Trägerschicht. Dies bedeutet insbesondere, dass Punkte auf der Innenfläche der ersten Trägerschicht und Punkte auf der Innenfläche der zweiten Trägerschicht, deren Verbindungslinien in einem Zustand ohne Temperaturdifferenz orthogonal zu den Innenflächen liegen, den nahezu selben Abstand beibehalten in einem Zustand mit großer Temperaturdifferenz.

In einer besonders bevorzugten Ausführungsform vollzieht die Legierung der ersten Trägerschicht im Betrieb eine ähnliche Ausdehnung wie die Halbleiterelemente und wie die Legierung der zweiten Trägerschicht.

Gemäß einer Weiterbildung der thermoelektrischen Vorrichtung umfasst die erste Trägerschicht eine erste Legierung, bei der
- der Anteil Nickel mindestens 32,0 Gew.-% und
- der Anteil Mangan höchstens 1,0 Gew.-% beträgt sowie
- mindestens ein Element aus der Gruppe Silizium, Chrom, Kohlenstoff, Molybdän, Kobalt, Aluminium, Titan und Niob und Eisen
enthalten ist.

Die erste Legierung dieser Weiterbildung besitzt einen Ausdehnungskoeffizienten von 2,0 * 10⁻⁶ /K bis 10,2 * 10⁻⁶ /K in einem Temperaturbereich von 200 °C bis 500 °C. Der niedrige Ausdehnungskoeffizient in diesem Temperaturbereich der ersten Legierung erlaubt es, die erste Legierung bei relativ hohen Temperaturen als Material für die Trägerschicht an der Heißseite einzusetzen.

Gemäß einer weiteren vorteilhaften Ausgestaltung der thermoelektrischen Vorrichtung besteht die erste Trägerschicht aus einer ersten Legierung, bei der
- der Anteil Nickel zwischen 28,0 Gew.-% und 30,0 Gew.-%,
- der Anteil Kobalt zwischen 16,0 Gew.-% und 18,0 Gew.-%,
- der Anteil Chrom höchstens 0,1 Gew.-%,
- der Anteil Kohlenstoff höchstens 0,05 Gew.-%,
- der Anteil Mangan höchstens 0,5 Gew.-%, und
- der Anteil Silizium höchstens 0,3 Gew.-%
beträgt und der Rest aus Eisen und unvermeidbaren Verunreinigungen gebildet wird.

Diese vorstehend angegebene Legierung wird nachfolgend auch als "bevorzugtes Heißseite-Material" bezeichnet.

Dadurch, dass diese erste Legierung einen Ausdehnungskoeffizienten zwischen 5,8 * 10⁻⁶ /K und 6,1 * 10⁻⁶ /K im Temperaturbereich zwischen 200 °C und 500 °C aufweist, ist die erste Legierung vorteilhaft an den Ausdehnungskoeffizienten geeigneter Halbleiterelementen angepasst. Besonders vorteilhaft ist es, wenn die erste Legierung als Trägerschicht auf der Heißseite verwendet wird.

Durch Kobalt wird das Kornwachstum bei höheren Temperaturen gehemmt. Die Anlassbeständigkeit und Warmfestigkeit werden somit verbessert. Andererseits begünstig Kobalt die Graphitbildung. Bei erhöhter Konzentration wird auch die Wärmeleitfähigkeit erhöht. Chrom erhöht die Zugfestigkeit der Legierungen bei geringfügiger Verschlechterung der Dehnung. Höhere Chromgehalte verbessern die Warmfestigkeit.

Ebenfalls kann es vorteilhaft sein, wenn die erste Trägerschicht aus einer ersten Legierung besteht, bei der der Anteil Nickel zwischen 32,0 Gew.-% und 37,0 Gew.-%, der Anteil Mangan höchstens 0,6 Gew.-% und mindestens ein Element aus der Gruppe von Silizium, Chrom, Kobalt, Titan und Niob und Eisen enthalten ist. Die erste Legierung zeichnet sich durch einen Ausdehnungskoeffizienten von 2,0 * 10⁻⁶ /K bis 10,2 * 10⁻⁶ /K in einem Temperaturbereich von 200 °C bis 500 °C aus. Diese Legierungen sind damit besonders für die Trägerschicht der Heißseite geeignet. Molybdän erhöht die Zugfestigkeit und besonders die Warmfestigkeit. Zusammen mit Chrom und Nickel legiert, können hohe Streckgrenzen und Zähigkeitswerte erzielt werden.

Ebenso ist es möglich, dass die erste Trägerschicht aus einer ersten Legierung besteht, bei der der Anteil Nickel zwischen 37,0 Gew.-% und 43,5 Gew.-%, der Anteil Mangan höchstens 1,0 Gew.-%, der Anteil Silizium höchstens 0,4 Gew.-% und der Anteil Kohlenstoff höchstens 1,0 Gew.-% beträgt und kein Aluminium, Molybdän und Kupfer enthalten sind. Die erste Legierung zeichnet sich durch einen Ausdehnungskoeffizienten von 3,5 * 10⁻⁶ /K bis 9,3 * 10⁻⁶ /K in einem Temperaturbereich von 200 °C bis 500 °C aus. Diese Legierung ist damit besonders geeignet für die Trägerschicht der Heißseite.

Ebenfalls vorteilhaft ist es, wenn die erste Trägerschicht aus einer ersten Legierung besteht, bei der der Anteil Nickel zwischen 45,0 Gew.-% und 52,0 Gew.-%, der Anteil Mangan höchstens 0,8 Gew.-%, der Anteil Silizium höchstens 0,5 Gew.-% und mindestens ein Element aus der Gruppe Kohlenstoff, Chrom und Aluminium und Eisen enthalten ist. Die erste Legierung zeichnet sich durch einen Ausdehnungskoeffizienten von 8,0 * 10⁻⁶ /K bis 10,0 * 10⁻⁶/K in einem Temperaturbereich von 200 °C bis 500 °C aus. Diese Legierungen sind damit besonders geeignet für die Trägerschicht der Heißseite und können vorteilhafterweise mit Halbleiterelementen kombiniert werden, die einen entsprechenden Ausdehnungskoeffizienten aufweisen.

Ebenfalls vorteilhaft ist es, wenn die erste Trägerschicht aus einer ersten Legierung besteht, bei der der Anteil Nickel zwischen 41,0 Gew.-% und 43,5 Gew.-%, der Anteil Mangan höchstens 0,6 Gew.-%, der Anteil Silizium höchstens 1,0 Gew.-% und der Anteil Chrom höchstens 6,0 Gew.-% und mindestens ein Element aus der Gruppe Aluminium, Kobalt und Titan und Eisen enthalten ist. Die erste Legierung zeichnet sich durch einen Ausdehnungskoeffizienten von 7,3 * 10⁻⁶ /K bis 14,4 * 10⁻⁶ /K in einem Temperaturbereich von 200 °C bis 500 °C aus.

Ebenfalls vorteilhaft ist es, wenn die zweite Trägerschicht aus einer zweiten Legierung besteht, bei der
- der Anteil Nickel zwischen 12,5 Gew.-% und 23,0 Gew.-%,
- der Anteil Mangan höchstens 7,0 Gew.-%,
- der Anteil Silizium höchstens 1,0 Gew.-%, und
- der Anteil Kohlenstoff 0,65 Gew.-% beträgt
und evtl. Chrom und Eisen enthalten ist.

Diese Legierung zeichnet sich durch einen Ausdehnungskoeffizienten von 18,9 * 10⁻⁶ /K bis 20,7 * 10⁻⁶ /K in einem Temperaturbereich von 20 °C bis 200 °C aus. Diese Legierung ist somit für die Trägerschicht der Kaltseite geeignet, wenn der Ausdehnungsunterschied von Heiß- und Kaltseite durch einen Ausdehnungskoeffizienten dieser Größe kompensiert wird. Auf diese Weise sind die absoluten Ausdehnungen der zweiten Trägerschicht, die mit der Kaltseite in thermischen Kontakt steht, und der ersten Trägerschicht, die mit der Heißseite in thermischen Kontakt steht, auch bei sehr großen Temperaturunterschieden nahezu gleich.

In einer weiteren vorteilhaften Ausgestaltung der thermoelektrischen Vorrichtungen besteht die zweite Trägerschicht aus einer zweiten Legierung, bei der
- der Anteil Nickel zwischen 9,0 Gew.-% und 11,0 Gew.-%,
- der Anteil Kupfer zwischen 17,0 Gew.-% und 19,0 Gew.-%,
- der Anteil Eisen höchstens 1,0 Gew.-%,
- der Anteil Kohlenstoff höchstens 0,1 Gew.-%, und
- der Anteil Silizium höchstens 0,25 Gew.-% beträgt
und der Rest aus Mangan besteht.

Diese vorstehend angegebene zweite Legierung wird nachfolgend auch als "bevorzugtes Kaltseite-Material" bezeichnet.

Diese erfindungsgemäße Legierung besitzt einen Ausdehnungskoeffizienten zwischen 26,8 * 10⁻⁶ /K und 28,4 * 10⁻⁶ /K in einem Temperaturbereich zwischen 20 °C. und 200 °C. Aufgrund des hohen Ausdehnungskoeffizienten ist die Legierung besonders geeignet die zweite Trägerschicht zu bilden, welche mit der Kaltseite in thermischen Kontakt steht.

Besonders bevorzugt ist die Kombination, bei der das "bevorzugte Heißseite-Material" die erste Trägerschicht und das "bevorzugte Kaltseite-Material" die zweite Trägerschicht bilden. Auf diese Weise besitzt die erste Trägerschicht einen Ausdehnungskoeffizienten, der dem der Halbleiterelemente nahezu entspricht, und die zweite Trägerschicht dehnt sich bei einem im Betrieb vorliegenden Temperaturunterschied von bis zu 450°C genauso stark aus wie die Trägerschicht der Heißseite.

In einer weiteren bevorzugten Ausgestaltung der thermoelektrischen Vorrichtung sind die erste Trägerschicht und die zweite Trägerschicht zylindrisch geformt und zueinander konzentrisch angeordnet. Mit zylindrisch geformt ist ein länglicher Körper gemeint, der einen kreisähnlichen Querschnitt aufweist. Insbesondere ist der Querschnitt nicht exakt ein Kreis, sondern kann auch etwa elliptisch sein. Ferner kann auch ein Rohr mit rechteckigem Querschnitt verwendet werden. Die erste Trägerschicht und die zweite Trägerschicht sind so ausgeformt, dass die Außenseite der ersten Trägerschicht, in dem Fall, dass die erste Trägerschicht die innere Trägerschicht bildet, überall nahezu den gleichen Abstand zur Innenseite der zweiten Trägerschicht besitzt. Bei einer solchen zylindrischen Anordnung bildet die Innenfläche der ersten Trägerschicht den wenigstens ersten Strömungskanal und die Außenfläche der zweiten Trägerschicht einen Teil der Begrenzung des wenigstens zweiten Strömungskanals. Damit ist eine Art konzentrisches Doppelrohr gebildet, wobei ein thermoelektrischer Generator eine Vielzahl solcher umfassen kann; Strömungskanäle für eines der Fluide sind dann innerhalb der Doppelrohre gebildet, während mindestens ein Strömungskanal für das andere Fluid außerhalb der Doppelrohre gebildet ist.

Ferner wird ein Kraftfahrzeug mit einem Verbrennungsmotor, einer Abgasanlage, einem Kühlkreislauf und mindestens einem thermischen Generator mit einer Mehrzahl von erfindungsgemäßen thermoelektrischen Vorrichtungen vorgeschlagen, wobei der wenigstens eine erste Strömungskanal mit der Abgasanlage und der wenigstens eine zweite Strömungskanal mit dem Kühlkreislauf verbunden ist.

Es wird ferner ein Verfahren zur Herstellung einer thermoelektrischen Vorrichtung vorgeschlagen, welches zumindest folgende Schritte umfasst:
- Bereitstellen einer ersten Trägerschicht, bestehend aus einer Legierung gemäß einem der Patentansprüche 3 oder 4;
- Bereitstellen einer ersten elektrischen Isolationsschicht für die erste Trägerschicht;
- Bereitstellen einer zweiten elektrischen Isolationsschicht für die zweite Trägerschicht;
- Bereitstellen einer zweiten Trägerschicht, bestehend aus einer Legierung gemäß Patentanspruch 5;
- Anordnen einer Mehrzahl von p- und n-dotierten Halbleiterelementen zwischen der ersten Trägerschicht und der zweiten Trägerschicht;
- Montieren der ersten Trägerschicht und der zweiten Trägerschicht, so dass die Halbleiterelemente dazwischen angeordnet sind.

Die Aufzählung der einzelnen Schritte ist nicht im Sinne einer Reihenfolge zu verstehen, es können mehrere Schritte wiederholt, kombiniert und/oder vertauscht werden.

Zunächst wird eine erste Trägerschicht aus einer erfindungsgemäßen Legierung bereitgestellt, wobei die Trägerschicht aus runden und/oder rechteckigen Platten bestehen kann, es kann aber auch ein Rohr als erste Trägerschicht verwendet werden. Der Querschnitt des Rohres ist bevorzugt kreisähnlich, kann aber auch elliptisch ausgeformt sein. Ferner ist auch ein Rohr mit rechteckigem Querschnitt vorstellbar.

Mit Hilfe eines Tauchbades, eines Siebdruckverfahrens, eines Sputterverfahrens oder eines anderen Verfahrens wird die elektrische Isolationsschicht bevorzugt auf die erste Trägerschicht aufgebracht. Die elektrische Isolationsschicht besteht dabei bevorzugt aus einem Dielektrikum, besonders bevorzugt aus SiO₂.

Eine Mehrzahl von p- und n-dotierten Halbleiterelementen, die z. B. eine quaderförmige Form oder aber auch eine ringförmige Form aufweisen können, werden elektrisch miteinander verbunden und insbesondere wechselweise in Reihe geschaltet. Die p- und n-dotierten Halbleiterelemente werden insbesondere durch elektrisch leitende Verbindungen so verschaltet, dass sie als thermoelektrische Elemente einen Strom erzeugen können. Die Halbleiterelemente können bereits vor dem Anordnen p-bzw. n-dotiert sein, sie können aber auch erst nach dem Anordnen zumindest eine Dotierung (p oder n) erhalten.

Die zweite Trägerschicht wird hierbei insbesondere aus dem "bevorzugten Kaltseite-Material" gebildet und mit einer elektrischen Isolationsschicht beaufschlagt. Im Anschluss werden die erste Trägerschicht, bevorzugt gebildet mit dem "bevorzugten Heißseite-Material", und die zweite Trägerschicht so zusammengefügt, dass die Halbleiterelemente zwischen der ersten Trägerschicht und der zweiten Trägerschicht angeordnet sind. Das Montieren kann mittels Löten, Schweißen oder anderen Fügeverfahren und auch mit Hilfe von Haltemitteln wie Rahmen, Steckverbindungen oder Schrauben erfolgen.

Darüber hinaus wird eine Verwendung einer ersten Legierung gemäß dem "bevorzugten Heißseite-Material" und/oder eine Verwendung einer zweiten Legierung gemäß dem "bevorzugten Kaltseite-Material" für die Aufnahme von Halbleiterelementen bei einem thermoelektrischen Generator als besonders vorteilhaft angesehen. Zur den Verwendungsmöglichkeiten im Einzelnen kann auf die gesamte Offenbarung hier zurückgegriffen werden.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung zeigen, diese jedoch nicht darauf beschränkt ist. Es zeigen schematisch:
Fig. 1: eine thermoelektrische Vorrichtung im Querschnitt, und
Fig. 2: ein Kraftfahrzeug mit einer thermoelektrischen Vorrichtung.

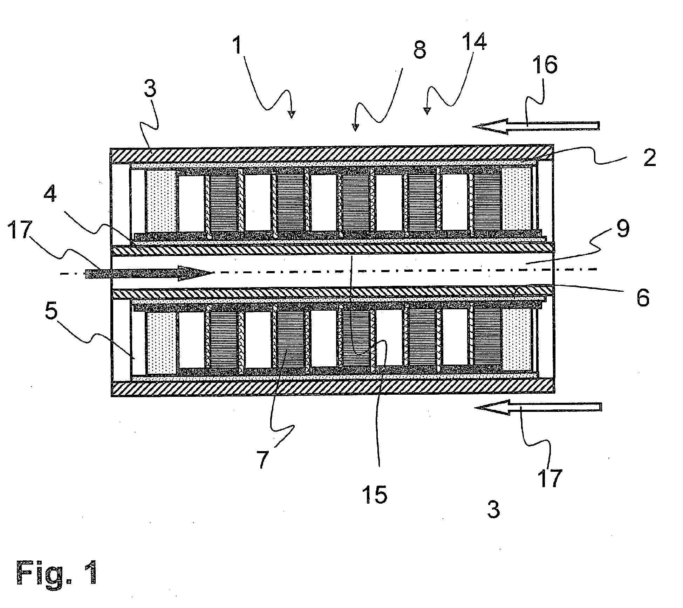

Fig. 1 zeigt eine zylindrische Anordnung einer thermoelektrischen Vorrichtung 1 in einer Schnittdarstellung durch die Längsachse. Eine erste Trägerschicht 3 bildet in diesem Ausführungsbeispiel eine äußere Hülle, die in thermisch leitenden Kontakt mit einem ersten Fluid 16 steht, und so einen Teil der Begrenzung eines ersten Strömungskanals 8 bildet. Auf der Innenseite der ersten Trägerschicht 3 befindet sich eine erste Isolationsschicht 2, die die erste Trägerschicht 3 gegenüber Halbleiterelementen 7 elektrisch isoliert, aber den Wärmefluss zwischen der ersten Trägerschicht 3 und den Halbleiterelementen 7 kaum beeinflusst. Die Halbleiterelemente 7 sind in einem Zwischenraum 5 zwischen der ersten Trägerschicht 3 und einer zweiten Trägerschicht 4 angeordnet. Die p- und n-dotierten Halbleiterelemente 7 sind wechselweise zwischen der ersten Isolationsschicht 2 und einer zweiten Isolationsschicht 6 angeordnet und elektrisch miteinander verbunden und in Reihe geschaltet. Die zweite Isolationsschicht 6 bildet eine elektrische Isolierung der Halbleiterelemente 7 gegenüber der zweiten Trägerschicht 4. Die zweite Trägerschicht 4 steht in thermisch leitenden Kontakt mit einem zweiten Fluid 17 und bildet in diesem Ausführungsbeispiel einen zweiten Strömungskanal 9. Es kann sowohl der erste Strömungskanal 8 oder der zweite Strömungskanal 9 die Heißseite 14 bilden, so dass der zweite/erste Strömungskanal die Kaltseite 15 bildet.

In dem Ausführungsbeispiel (für ein Abgasrtickführsystem) ist zumindest die erste Trägerschicht 3 oder die zweite Trägerschicht 4 aus einer erfindungsgemäßen Legierung. Die Legierung der anderen (zweiten oder ersten) Trägerschicht kann aus einem anderen Material bestehen. In einer Ausführungsform sind die Legierungen, aus denen die erste Trägerschicht 3 und die zweite Trägerschicht 4 bestehen, so gewählt, dass die Ausdehnung der ersten Trägerschicht 3 gegenüber der zweiten Trägerschicht 4 bei einem Temperaturunterschied kompensiert wird. Temperaturen im Betrieb sind dabei zwischen 20 °C und 110 °C, typischerweise zwischen 50 °C und 80 °C, auf der Kaltseite 15 und zwischen 150 °C und 500 °C, typischerweise zwischen 250 °C und 400 °C, auf der Heißseite 14.

Bei einer weiteren vorteilhaften Ausführungsform wird die Legierung für die erste Trägerschicht 3 auf der Heißseite 14 so gewählt, dass der Ausdehnungskoeffizient der Legierung nahezu dem Ausdehnungskoeffizienten der Halbleiterelemente 7 entspricht. Auf diese Weise entstehen keine Spannungen zwischen der ersten Trägerschicht 3 und den Halbleiterelementen 7 bei einer Temperaturänderung. Die Legierung für die zweite Trägerschicht 4 an der Kaltseite 15 wird so gewählt, dass sie sich im Betrieb trotz der geringeren Temperatur so stark ausdehnt wie die erste Trägerschicht 3.

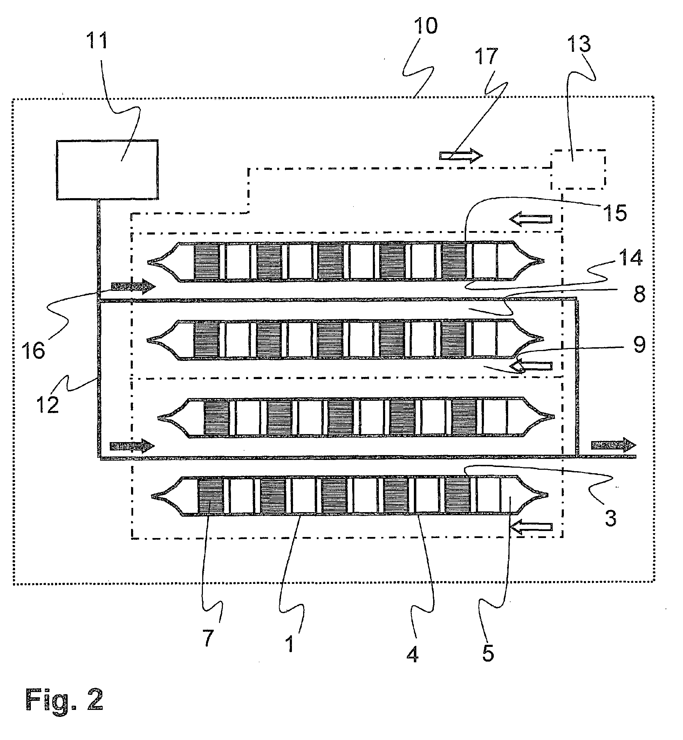

Fig. 2 stellt schematisch ein Kraftfahrzeug 10 mit einer thermoelektrischen Vorrichtung 1, einem Verbrennungsmotor 11, einer Abgasanlage 12 und einem Kühlkreislauf 13 dar. Der Verbrennungsmotor 11 ist an die Abgasanlage 12 angeschlossen und stellt ein erstes Fluid 16 bereit, das eine Heißseite 14 bedingt und durch einen ersten Strömungskanal 8 strömt. Der Kühlkreislauf 13 stellt ein zweites Fluid 17 bereit, das eine Kaltseite 15 bedingt und durch einen zweiten Strömungskanal 9 geführt wird. Es kann dabei eine Vielzahl von ersten Strömungskanälen 8 und zweiten Strömungskanälen 9 gebildet werden mit dazwischen angeordneten thermoelektrischen Vorrichtungen 1.

Zwischen den Strömungskanälen sind die thermoelektrischen Vorrichtungen 1 angeordnet. Dabei ist die erste Trägerschicht 3 in thermisch leitendem Kontakt mit dem ersten Fluid 16, das die Heißseite 14 bildet, und die zweite Trägerschicht 4 in thermisch leitendem Kontakt mit dem zweiten Fluid 17, welches die Kaltseite 15 bildet. In einem Zwischenraum 5 zwischen der ersten Trägerschicht 3 und der zweiten Trägerschicht 4 sind die Halbleiterelemente 7 angeordnet, die aufgrund der Temperaturdifferenz zwischen der Heißseite 14 und der Kaltseite 15 einen Strom ("Seebeck-Effekt") generieren. Die Legierungen der ersten Trägerschicht 3 und der zweiten Trägerschicht 4 sind dabei so gewählt, dass sich ihre Wärmeausdehnung bei unterschiedlichen Temperaturen kompensieren.

### Bezugszeichenliste

- 1: thermoelektrische Vorrichtung
- 2: erste Isolationsschicht
- 3: erste Trägerschicht
- 4: zweite Trägerschicht
- 5: Zwischenraum
- 6: Isolationsschicht
- 7: Halbleiterelemente
- 8: erster Strömungskanal
- 9: zweiter Strömungskanal
- 10: Kraftfahrzeug
- 11: Verbrennungsmotor
- 12: Abgasanlage
- 13: Kühlkreislauf
- 14: Heißseite
- 15: Kaltseite
- 16: erstes Fluid
- 17: zweites Fluid

## Patentansprüche

1. Thermoelektrische Vorrichtung (1) aufweisend zumindest einen ersten Strömungskanal (8) und zumindest einen zweiten Strömungskanal (9) mit
- wenigstens einer dem zumindest einen ersten Strömungskanal (8) zugeordneten ersten Trägerschicht (3) und wenigstens einer dem zumindest einen zweiten Strömungskanal (9) zugeordneten zweiten Trägerschicht (4),
- wenigstens einem Zwischenraum (5) zwischen der ersten Trägerschicht (3) und der zweiten Trägerschicht (4),
- einer Mehrzahl von p- und n-dotierten Halbleiterelementen (7), die in dem wenigstens einen Zwischenraum (5) angeordnet und elektrisch miteinander verbunden sind,
wobei eine relative erste thermische Ausdehnung der ersten Trägerschicht und eine relative zweite Ausdehnung der zweiten Trägerschicht unter Betriebsbedingungen gleich sind; wobei die relative thermische Ausdehnung sich aus dem Produkt eines gemittelten Ausdehnungskoeffizienten der Trägerschicht und der Temperaturdifferenz, die diese Trägerschicht unter Betriebsbedingungen der thermoelektrischen Vorrichtung ausgesetzt ist, ergibt;
**dadurch gekennzeichnet, dass** die erste Trägerschicht einen Ausdehnungskoeffizienten von 2 * 10⁻⁶ /K bis 10,2 * 10⁻⁶ /K und die zweite Trägerschicht einen Ausdehnungskoeffizienten von 12 * 10⁻⁶/K bis 28.4 * 10⁻⁶ /K aufweist.

2. Thermoelektrische Vorrichtung (1) aufweisend zumindest einen ersten Strömungskanal (8) und zumindest einen zweiten Strömungskanal (9) mit
- wenigstens einer dem zumindest einen ersten Strömungskanal (8) zugeordneten ersten Trägerschicht (3) und wenigstens einer dem zumindest einen zweiten Strömungskanal (9) zugeordneten zweiten Trägerschicht (4),
- wenigstens einem Zwischenraum (5) zwischen der ersten Trägerschicht (3) und der zweiten Trägerschicht (4),
- einer Mehrzahl von p- und n-dotierten Halbleiterelementen (7), die in dem wenigstens einen Zwischenraum (5) angeordnet und elektrisch miteinander verbunden sind,
wobei eine relative erste thermische Ausdehnung der ersten Trägerschicht und eine relative zweite Ausdehnung der zweiten Trägerschicht unter Betriebsbedingungen gleich sind; wobei die relative thermische Ausdehnung sich aus dem Produkt eines gemittelten Ausdehnungskoeffizienten der Trägerschicht und der Temperaturdifferenz, die diese Trägerschicht unter Betriebsbedingungen der thermoelektrischen Vorrichtung ausgesetzt ist, ergibt;
**dadurch gekennzeichnet, dass**
zumindest die erste Trägerschicht (3) oder die zweite Trägerschicht (4) aus einer Legierung besteht, bei der ein Anteil Nickel von mindestens 9,0 Gew.-%, ein Anteil Silizium von höchstens 1,0 Gew.-%, sowie mindestens ein Element aus der Gruppe Mangan, Chrom, Kohlenstoff, Molybdän, Kobalt, Aluminium, Titan, Kupfer und Niob und Eisen enthalten ist.

3. Thermoelektrische Vorrichtung (1) gemäß Patentanspruch 2, wobei die erste Trägerschicht (3) aus einer ersten Legierung besteht, bei der der Anteil Nickel mindestens 32,0 Gew.-% und der Anteil Mangan höchstens 1,0 Gew.-% beträgt und die kein Kupfer enthält.

4. Thermoelektrische Vorrichtung (1) gemäß einem der Patentansprüche 2 oder 3, wobei die erste Trägerschicht (3) aus einer Legierung besteht, bei der der Anteil Nickel zwischen 28,0 Gewichts-% und 30,0 Gewichts-%, der Anteil Kobalt zwischen 16,0 Gewichts-% und 18,0 Gew.%, der Anteil Chrom höchstens 0,1 Gew.-%, der Anteil Kohlenstoff höchstens 0,05 Gew.-%, der Anteil Mangan höchstens 0,5 Gew.-% und der Anteil Silizium höchstens 0,3 Gew.-% beträgt.

5. Thermoelektrische Vorrichtung gemäß einem der Patentansprüche 2 bis 4, wobei die zweite Trägerschicht (4) aus einer zweiten Legierung besteht, bei der der Anteil Nickel zwischen 9,0 Gew.-% und 11,0 Gew.%, der Anteil Kupfer zwischen 17,0 Gew.-% und 19,0 Gew.-%, der Anteil Eisen höchstens 1,0 Gew.-%, der Anteil Kohlenstoff höchstens 0,1 Gew.-% und der Anteil Silizium höchstens 0,25 Gew.-% beträgt und der Rest aus Mangan besteht.

6. Thermoelektrische Vorrichtung (1) gemäß einem der vorhergehenden Patentansprüche, wobei die erste Trägerschicht (3) und die zweite Trägerschicht (4) zylindrisch geformt und zueinander konzentrisch angeordnet sind.

7. Kraftfahrzeug (10) mit einem Verbrennungsmotor (11), einer Abgasanlage (12), einem Kühlkreislauf (13) und mindestens ein thermischer Generator mit einer Mehrzahl von thermoelektrischen Vorrichtungen (1) gemäß einem der vorhergehenden Patentansprüche, wobei der erste Strömungskanal (8) mit der Abgasanlage (12) und der zweite Strömungskanal (9) mit dem Kühlkreislauf (13) verbunden sind.

8. Verfahren zur Herstellung einer thermoelektrischen Vorrichtung (1), umfassend zumindest folgende Schritte:
- Bereitstellen einer ersten Trägerschicht (3), bestehend aus einer Legierung gemäß einem der Patentansprüche 2 oder 3;
- Bereitstellen einer ersten elektrischen Isolationsschicht (6) für die erste Trägerschicht (3);
- Bereitstellen einer zweiten elektrischen Isolationsschicht (6) für die zweite Trägerschicht (4);
- Bereitstellen einer zweiten Trägerschicht (4), bestehend aus einer Legierung gemäß Patentanspruch 5;
- Anordnen einer Mehrzahl von p- und n- dotierten Halbleiterelementen (7) zwischen der ersten Trägerschicht (3) und der zweiten Trägerschicht (4);
- Montieren der ersten Trägerschicht und der zweiten Trägerschicht, so dass die Halbleiterelemente dazwischen angeordnet sind.

## Claims

1. Thermoelectric device (1) comprising at least one first flow duct (8) and at least one second flow duct (9), having
- at least one first carrier layer (3) which is assigned to the at least one first flow duct (8) and at least one second carrier layer (4) which is assigned to the at least one second flow duct (9),
- at least one intermediate space (5) between the first carrier layer (3) and the second carrier layer (4), and
- a multiplicity of p-doped and n-doped semiconductor elements (7) which are arranged in the at least one intermediate space (5) and are electrically connected to one another,
wherein a relative first thermal expansion of the first carrier layer and a relative second expansion of the second carrier layer are the same under operating conditions; wherein the relative thermal expansion results from the product of an averaged coefficient of expansion of the carrier layer and the difference in temperature which this carrier layer is subjected to under operating conditions of the thermoelectric device;
**characterized in that** the first carrier layer has an coefficient of expansion of 2 * 10⁻⁶ /K to 10.2* 10⁻⁶ /K and the second carrier layer has an coefficient of expansion of 12 * 10⁻⁶/K to 28.4 * 10⁻⁶ /K.

2. Thermoelectric device (1) comprising at least one first flow duct (8) and at least one second flow duct (9), having
- at least one first carrier layer (3) which is assigned to the at least one first flow duct (8) and at least one second carrier layer (4) which is assigned to the at least one second flow duct (9),
- at least one intermediate space (5) between the first carrier layer (3) and the second carrier layer (4), and
- a multiplicity of p-doped and n-doped semiconductor elements (7) which are arranged in the at least one intermediate space (5) and are electrically connected to one another,
wherein a relative first thermal expansion of the first carrier layer and a relative second expansion of the second carrier layer are the same under operating conditions; wherein the relative thermal expansion results from the product of an averaged coefficient of expansion of the carrier layer and the difference in temperature which this carrier layer is subjected to under operating conditions of the thermoelectric device;
**characterized in that** the at least first carrier layer (3) or the second carrier layer (4) is composed of an alloy containing a proportion of nickel of at least 9.0 % by weight, a proportion of silicon of at most 1.0% by weight and at least one element from the group manganese, chromium, carbon, molybdenum, cobalt, aluminum, titanium, copper and niobium and iron.

3. Thermoelectric device (1) as claimed in patent claim 2, wherein the first carrier layer (3) is composed of a first alloy in which the proportion of nickel is at least 32.0% by weight and the proportion of manganese is at most 1.0% by weight and which does not contain any copper.

4. Thermoelectric device (1) as claimed in one of the patent claims 2 or 3, wherein the first carrier layer (3) is composed of an alloy in which the proportion of nickel is between 28.0% by weight and 30.0% by weight, the proportion of cobalt is between 16.0% by weight and 18.0% by weight, the proportion of chromium is at most 0.1% by weight, the proportion of carbon is at most 0.05% by weight, the proportion of manganese is at most 0.5% by weight and the proportion of silicon is at most 0.3% by weight.

5. Thermoelectric device (1) as claimed in one of patent claims 2 to 4, wherein the second carrier layer (4) is composed of a second alloy in which the proportion of nickel is between 9.0% by weight and 11.0% by weight, the proportion of copper is between 17.0% by weight and 19.0% by weight, the proportion of iron is at most 1.0% by weight, the proportion of carbon is at most 0.1% by weight and the proportion of silicon is at most 0.25% by weight, and the rest is composed of manganese.

6. Thermoelectric device (1) as claimed in one of the preceding patent claims, wherein the first carrier layer (3) and the second carrier layer (4) are shaped cylindrically and are arranged concentrically with respect to one another.

7. Motor vehicle (10) having an internal combustion engine (11), an exhaust system (12), a cooling circuit (13) and at least one thermal generator having a plurality of thermoelectric devices (1) as claimed in one of the preceding patent claims, wherein the first flow duct (8) is connected to the exhaust system (12), and the second flow duct (9) is connected to the cooling circuit (13).

8. Method for manufacturing a thermoelectric device (1) comprising at least the following steps:
- provision of a first carrier layer (3), composed of an alloy as claimed in one of patent claims 2 or 3;
- provision of a first electrical insulation layer (6) for the first carrier layer (3);
- provision of a second electrical insulation layer (6) for the second carrier layer (4);
- provision of a second carrier layer (4), composed of an alloy as claimed in patent claim 5;
- arrangement of a multiplicity of p-doped and n-doped semiconductor elements (7) between the first carrier layer (3) and the second carrier layer (4); and
- mounting of the first carrier layer and of the second carrier layer, with the result that the semiconductor elements are arranged between them.

## Revendications

1. Dispositif thermoélectrique (1) présentant au moins un premier canal d'écoulement (8) et au moins un deuxième canal d'écoulement (9), avec
- au moins une première couche de support (3) associée audit au moins un premier canal d'écoulement (8) et au moins une deuxième couche de support (4) associée audit au moins un deuxième canal d'écoulement (9),
- au moins une chambre intermédiaire (5) entre la première couche de support (3) et la deuxième couche de support (4),
- une multiplicité d'éléments semi-conducteurs à dopage p et n (7), qui sont disposés dans ladite au moins une chambre intermédiaire (5) et qui sont électriquement reliés les uns aux autres,
dans lequel une première dilatation thermique relative de la première couche de support et une deuxième dilatation relative de la deuxième couche de support sont égales dans des conditions de fonctionnement;
dans lequel la dilatation thermique relative résulte du produit d'un coefficient de dilatation moyen de la couche de support et de la différence de température à laquelle cette couche de support est exposée dans les conditions de fonctionnement du dispositif thermoélectrique;
**caractérisé en ce que** la première couche de support présente un coefficient de dilatation de 2*10⁻⁶/K à 10,2*10⁻⁶/K et la deuxième couche de support présente un coefficient de dilatation de 12*10⁻⁶/K à 28,4*10⁻⁶/K.

2. Dispositif thermoélectrique (1) présentant au moins un premier canal d'écoulement (8) et au moins un deuxième canal d'écoulement (9), avec
- au moins une première couche de support (3) associée audit au moins un premier canal d'écoulement (8) et au moins une deuxième couche de support (4) associée audit au moins un deuxième canal d'écoulement (9),
- au moins une chambre intermédiaire (5) entre la première couche de support (3) et la deuxième couche de support (4),
- une multiplicité d'éléments semi-conducteurs à dopage p et n (7), qui sont disposés dans ladite au moins une chambre intermédiaire (5) et qui sont électriquement reliés les uns aux autres,
dans lequel une première dilatation thermique relative de la première couche de support et une deuxième dilatation relative de la deuxième couche de support sont égales dans des conditions de fonctionnement;
dans lequel la dilatation thermique relative résulte du produit d'un coefficient de dilatation moyen de la couche de support et de la différence de température à laquelle cette couche de support est exposée dans les conditions de fonctionnement du dispositif thermoélectrique;
**caractérisé en ce qu'**au moins la première couche de support (3) ou la deuxième couche de support (4) se compose d'un alliage qui contient une proportion de nickel d'au moins 9,0 % en poids, une proportion de silicium d'au plus 1,0 % en poids, ainsi qu'au moins un élément du groupe manganèse, chrome, carbone, molybdène, cobalt, aluminium, titane, cuivre et niobium et fer.

3. Dispositif thermoélectrique (1) selon la revendication 2, dans lequel la première couche de support (3) se compose d'un premier alliage, dans lequel la proportion de nickel vaut au moins 32,0 % en poids et la proportion de manganèse vaut au plus 1,0 % en poids et qui ne contient pas de cuivre.

4. Dispositif thermoélectrique (1) selon une des revendications 2 ou 3, dans lequel la première couche de support (3) se compose d'un alliage dans lequel la proportion de nickel vaut entre 28,0 % en poids et 30,0 % en poids, la proportion de cobalt vaut entre 16,0 % en poids et 18,0 % en poids, la proportion de chrome vaut au plus 0,1 % en poids, la proportion de carbone vaut au plus 0,05 % en poids, la proportion de manganèse vaut au plus 0,5 % en poids et la proportion de silicium vaut au plus 0,3 % en poids.

5. Dispositif thermoélectrique (1) selon l'une quelconque des revendications 2 à 4, dans lequel la deuxième couche de support (4) se compose d'un deuxième alliage dans lequel la proportion de nickel vaut entre 9,0 % en poids et 11,0 % en poids, la proportion de cuivre vaut entre 17,0 % en poids et 19,0 % en poids, la proportion de fer vaut au plus 1,0 % en poids, la proportion de carbone vaut au plus 0,1 % en poids et la proportion de silicium vaut au plus 0,25 % en poids et le reste est constitué de manganèse.

6. Dispositif thermoélectrique (1) selon l'une quelconque des revendications précédentes, dans lequel la première couche de support (3) et la deuxième couche de support (4) sont de forme cylindrique et sont disposées de façon concentrique l'une par rapport à l'autre.

7. Véhicule automobile (10) avec un moteur à combustion interne (11), une installation de gaz d'échappement (12), un circuit de refroidissement (13) et au moins un générateur thermique avec une multiplicité de dispositifs thermoélectriques (1) selon l'une quelconque des revendications précédentes, dans lequel le premier canal d'écoulement (8) est raccordé à l'installation de gaz d'échappement (12) et le deuxième canal d'écoulement (9) est raccordé au circuit de refroidissement (13).

8. Procédé de fabrication d'un dispositif thermoélectrique (1), comprenant au moins les étapes suivantes:
- préparer une première couche de support (3), se composant d'un alliage selon une des revendications 2 ou 3;
- préparer une première couche d'isolation électrique (6) pour la première couche de support (3);
- préparer une deuxième couche d'isolation électrique (6) pour la deuxième couche de support (4);
- préparer une deuxième couche de support (4), se composant d'un alliage selon la revendication 5;
- disposer une multiplicité d'éléments semi-conducteurs à dopage p et n (7) entre la première couche de support (3) et la deuxième couche de support (4);
- monter la première couche de support et la deuxième couche de support, d'une manière telle que les éléments semi-conducteurs soient disposés entre celles-ci.
